# EUROPÄISCHE PATENTSCHRIFT

(11) **EP 0 750 343 B1**
(45) Veröffentlichungstag und Bekanntmachung des Hinweises auf die Patenterteilung: **22.10.1997**
(21) Anmeldenummer: 95109853.2
(22) Anmeldetag: 23.06.1995
(51) Int. Cl.: H01L 23/525

(54) **Bank von Schmelzsicherungen mit ESD-Schutz**
Fusebank with ESD protection
Banque de fusibles comprenant une protection contre la décharge electrostatique

(43) Veröffentlichungstag der Anmeldung: 27.12.1996
(73) Patentinhaber: SIEMENS AKTIENGESELLSCHAFT, 80333 München (DE)
(72) Erfinder: Reczek, Werner, Dr. Ing., D-85521 Ottobrunn (DE); Savignac, Dominique, Dr. rer. nat., D-85737 Ismaning (DE); Terletzki, Hartmud, D-81827 München (DE); Hebbeker, Heinz, D-82435 Bayersoien (DE)

(56) Entgegenhaltungen:
- EP-A- 0 076 967
- PATENT ABSTRACTS OF JAPAN vol. 009 no. 248 (E-347) ,4.Oktober 1985 & JP-A-60 098664 (MITSUBISHI DENKI KK) 1.Juni 1985,
- PATENT ABSTRACTS OF JAPAN vol. 014 no. 055 (E-0882) ,31.Januar 1990 & JP-A-01 278745 (MATSUSHITA ELECTRON CORP) 9.November 1989,
- PATENT ABSTRACTS OF JAPAN vol. 018 no. 359 (E-1574) ,6.Juli 1994 & JP-A-06 097379 (YAMAHA CORP) 8.April 1994,

## Beschreibung

Die Erfindung betrifft eine Bank von Schmelzsicherungen (Fusebank) gemäß dem Oberbegriff des Anspruchs 1. Eine solche Bank von Schmelzsicherungen ist aus der EP-A 0 076 967 bekannt.

Bänke von Schmelzsicherungen sind Teile integrierter Schaltungen. Eine Bank von Schmelzsicherungen weist oberhalb eines Halbleitersubstrates einer integrierten Schaltung eine von diesem isolierte Schmelzsicherung (Fuse-Link) auf. Schmelzsicherungen (Fuse-Links, auch kurz "Fuses" genannt) sind Teile von elektrisch leitfähigen Bereichen die - beispielsweise mechanisch oder thermisch - auftrennbar bzw. zerstörbar sind. Wie allgemein bekannt, kann durch selektives Auftrennen der Schmelzsicherungen einer integrierten Schaltung gegen Ende ihres Herstellungsprozesses eine Konfigurierung der integrierten Schaltung erfolgen. Durch das Auftrennen der Schmelzsicherungen, welches gewöhnlich mittels eines Lasers geschieht, wird eine Schutzschicht über der integrierten Schaltung im Bereich der Schmelzsicherungen zerstört und es kann dazu kommen, daß geladene Teilchen (Ionen) in das unter den Schmelzsicherungen befindliche Substrat gelangen. Um eine Wanderung dieser Ionen durch das Substrat zu verhindern, sind oftmals sogenannte Schutzringzonen ("Guardringe") vorgesehen, die einen Bereich um die Schmelzsicherung umschließen. Die Schutzringzonen sind dabei unterhalb der Schmelzsicherungen im Substrat um die Schmelzsicherungen herum angeordnet und können beispielsweise als Diffusionen realisiert sein.

Diese Schutzringzonen üben eine sogenannte "Getter-Funktion" aus, das heißt sie fangen Ionen auf. Dazu sind sie mit je einem Versorgungspotential der integrierten Schaltung verbunden.

Ist einer Schutzringzone (Guardring), die ja einen ersten dotierten Bereich darstellt, ein zweiter dotierter Bereich vom gleichen Leitungstyp benachbart und ist dieser zweite dotierte Bereich mit einem anderen Versorgungspotential als der erste dotierte Bereich verbunden, kann es bei Auftreten von ESD (electro-static discharge) zu einem Durchbruch des durch die beiden dotierten Bereiche und die dazwischenliegende Isolierung gebildeten parasitären Feldeffekttransistors kommen. Um einen zerstörenden Durchbruch des parasitären Transistors zu verhindern, kann der Abstand zwischen den beiden dotierten Bereichen erhöht werden, so daß sich auch die Durchbruchspannung erhöht. Dies erfordert jedoch zusätzliche Layoutfläche.

Der Erfindung liegt die Aufgabe zugrunde, eine andere Lösung zu finden, bei der ESD-Schäden am durch die beiden dotierten Bereiche gebildeten parasitären Transistor vermieden werden.

Diese Aufgabe wird gemäß Anspruch 1 gelöst.

Eine Weiterbildung der Erfindung ist im Unteranspruch gekennzeichnet.

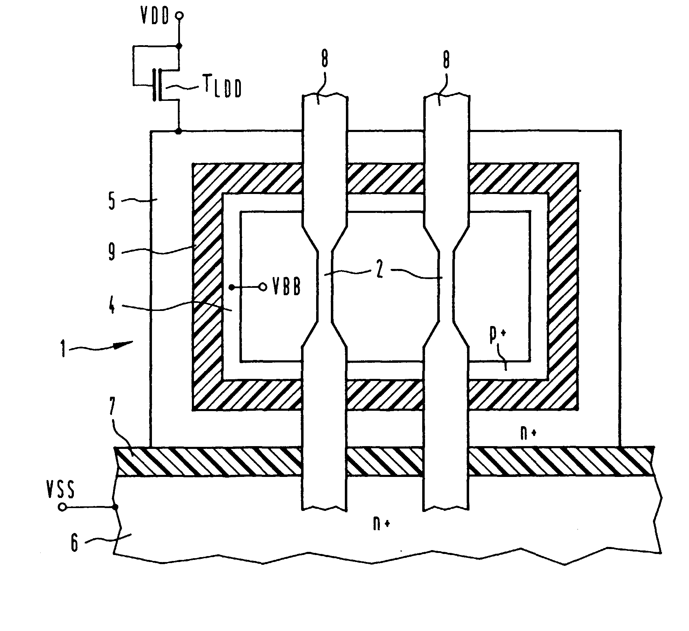

Die Erfindung soll im folgenden anhand der Figur näher erläutert werden.

Dargestellt ist eine Bank von Schmelzsicherungen in Draufsicht. Oberhalb eines Halbleitersubstrates 1 befinden sich bei diesem Ausführungsbeispiel zwei von diesem isolierte Schmelzsicherungen 2, welche jeweils Bestandteil eines breiteren leitenden Bereiches 8 sind. Unterhalb der Schmelzssicherungen 2 und diese umgebend befinden sich an der Oberfläche des Substrats 1 zwei Schutzringzonen (Guardringe). Eine der Schutzringzonen ist als ein erster dotierter Bereich 5, die andere Schutzringzone als ein dritter dotierter Bereich 4 realisiert. Beide Schutzringzonen sind vom entgegengesetzten Leitungstyp. Sie sind voneinander durch einen isolierenden Bereich 9 getrennt.

Der erste dotierte Bereich 5, der bei diesem Ausführungsbeispiel stark n-dotiert (n⁺) ist, ist über ein hochohmiges Halbleiterbauelement TLDD mit einem ersten Versorgungspotential VDD, welches beispielsweise positiv sein kann, verbunden. Das hochohmige Halbleiterbauelement TLDD ist bei diesem Ausführungsbeispiel als Transistor (LDD) mit leicht dotiertem Drain ("LDD-Transistor") realisiert, dessen Drain und Gate miteinander verbunden sind, so daß er wie eine Diode wirkt. Transistoren (LDD) mit leicht dotiertem Drain weisen Draingebiete (LDD = Lightly Doped Drain) auf, die an ihrer dem Gate zugewandten Seite weniger stark dotiert sind als weiter vom Gate entfernt. Hierdurch sind sie hochohmiger, als gewöhnliche Transistoren.

Der dritte dotierte Bereich 4 ist mit einem dritten Versorgungspotential VBB, welches beispielsweise eine negative Substratvorspannung sein kann, verbunden. Er kann bei anderen Ausführungsformen der Erfindung entfallen.

Dem ersten dotierten Bereich 5 benachbart und von diesem durch eine Isolierung 7 getrennt, befindet sich ein zweiter dotierter Bereich 6, der vom gleichen Leitungstyp ist wie der erste dotierte Bereich 5. Der zweite dotierte Bereich 6 ist jedoch mit einem zweiten Versorgungspotential VSS, welches beispielsweise Masse sein kann, verbunden. Kommt es nun zu einer elektrostatischen Belastung der Anschlußpins für das erste VDD oder zweite VSS Versorgungspotential, kann es zu einem Durchbruch des vom ersten 5 und zweiten 6 dotierten Bereich und der dazwischen liegenden Isolierung 7 gebildeten parasitären Transistors kommen. Da erfindungsgemäß jedoch das hochohmige Halbleiterbauelement TLDD zwischen dem ersten Versorgungspotential VDD und dem ersten dotierten Bereich 5 vorgesehen ist, wird der mit dem Durchbruch verbundene Strom in seiner Höhe begrenzt und es werden Beschädigungen vermieden.

Bei anderen Ausführungsformen der Erfindung ist es möglich, daß die dotierten Bereiche 4, 5, 7 vom umgekehrten Leitungstyp sind und daß die entsprechenden Versorgungspotentiale VBB, VDD, VSS andere Polarität aufweisen als beim geschilderten Ausführungsbeispiel.

## Patentansprüche

1. Bank von Schmelzsicherungen
- mit mindestens einer über einem Halbleitersubstrat (1) angeordneten und von diesem isolierten Schmelzsicherung (2),
- mit einem im Substrat (1), die Schmelzsicherung (2) umgebend, angeordneten ersten dotierten Bereich (5), der eine Schutzringzone bildet,
- und mit einem dem ersten dotierten Bereich (5) benachbarten und von diesem durch eine Isolierung (7) getrennten zweiten dotierten Bereich (6), der vom gleichen Leitungstyp (n⁺) ist wie der erste dotierte Bereich (5),
wobei der erste dotierte Bereich (5) mit einem ersten Versorgungspotential (VDD) verbunden ist und der zweite dotierte Bereich (6) mit einem anderen, zweiten Versorgungspotential (VSS) verbunden ist,
dadurch gekennzeichnet,
daß der die Schutzringzone bildende erste dotierte Bereich (5) über ein hochohmiges Halbleiterbauelement (TLDD) derart mit dem ersten Versorgungspotential (VDD) verbunden ist, daß ein aufgrund einer elektrostatischen Entladung auftretender Durchbruchs-Strom zwischen dem ersten und zweiten dotierten Bereich (5, 6) in seiner Höhe so begrenzt wird, daß Beschädigungen vermieden werden.

2. Bank nach Anspruch 1,
**dadurch gekennzeichnet**,
daß das hochohmige Halbleiterbauelement (TLDD) ein Transistor (LDD) mit leicht dotiertem Drain ist.

## Claims

1. Fuse bank
- having at least one fuse (2) arranged above a semiconductor substrate (1) and insulated therefrom,
- having a first doped region (5), which is arranged, surrounding the fuse (2), in the substrate (1) and forms a guard ring zone,
- and having a second doped region (6), which is adjacent to the first doped region (5), is separated therefrom via an insulation (7), and is of the same conduction type (n⁺) as the first doped region (5),
the first doped region (5) being connected to a first supply potential (VDD), and the second doped region (6) being connected to another, second supply potential (VSS), characterized in that the first doped region (5) forming the guard ring zone is connected to the first supply potential (VDD) via a high-impedance semiconductor component (TLDD) in such a way that the strength of a breakdown current, occurring owing to an electrostatic discharge, between the first and second doped regions (5, 6) is limited such that damage is avoided.

2. Bank according to Claim 1, characterized in that the high-impedance semiconductor component (TLDD) is a transistor (LDD) with a lightly doped drain.

## Revendications

1. Banc de fusibles comportant
- au moins un fusible (2) disposé au-dessus d'un substrat (1) semi-conducteur et isolé de celui-ci,
- une première zone dopée (5), qui est disposée dans le substrat (1), qui entoure le fusible (2) et qui forme une zone annulaire de protection,
- une deuxième zone dopée (6), qui est voisine de la première zone dopée (5) et qui est isolée de celle-ci par une isolation (7) qui est du même type de conduction (n⁺) que la première zone dopée (5),
la première zone dopée (5) étant reliée à un premier potentiel (VDD) d'alimentation et la seconde zone dopée (6) étant reliée à un autre second potentiel (VSS) d'alimentation,
**caractérisé en ce que**
la première zone dopée formant la zone annulaire de protection est reliée par l'intermédiaire d'un composant (TLDD) à semi-conducteur de grande impédance au premier potentiel (VDD) d'alimentation, de telle sorte qu'un courant de claquage apparaissant en raison d'une décharge électrostatique entre la première zone et la seconde zone (5, 6) dopée soit limité en intensité de sorte à empêcher des détériorations.

2. Banc suivant la revendication 1,
caractérisé en ce que
le composant (TLDD) à semi-conducteur de grande impédance est un transistor (LDD) à drain légèrement dopé.
